# EUROPEAN PATENT APPLICATION

(11) **EP 4 307 845 A1**
(43) Date of publication of application: **17.01.2024**
(21) Application number: 22306048.4
(22) Date of filing: 12.07.2022
(51) Int. Cl.: H05K 1/18, H05K 3/46

(54) **COMPONENT CARRIER WITH STAMPED DESIGN LAYER STRUCTURE AND EMBEDDED COMPONENT**

(71) Applicant: AT&S Austria Technologie & Systemtechnik Aktiengesellschaft, 8700 Leoben (AT)
(72) Inventor: Trischler, Heinrich, 8793 Trofaiach (AT); Scalbert, Marie, 8700 Leoben (AT); Preiner, Erich, 8770 St. Michael (AT)
(74) Representative: Dilg, Haeusler, Schindelmann Patentanwaltsgesellschaft mbH

(57) **Abstract**

A component carrier (100) which comprises a stack (102) comprising at least one electrically conductive layer structure (104) and at least one electrically insulating layer structure (106), wherein the at least one electrically insulating layer structure (106) comprises at least one design layer structure (108, 110) having a stamped surface profile, and a component (112) being embedded in the stack (102) and being at least partially covered by the at least one design layer structure (108, 110).

## Description

The invention relates to a component carrier and to a method of manufacturing a component carrier.

In the context of growing product functionalities of component carriers equipped with one or more electronic components and increasing miniaturization of such electronic components as well as a rising number of electronic components to be mounted on the component carriers such as printed circuit boards, increasingly more powerful array-like components or packages having several electronic components are being employed, which have a plurality of contacts or connections, with ever smaller spacing between these contacts. Removal of heat generated by such electronic components and the component carrier itself during operation becomes an increasing issue. At the same time, component carriers shall be mechanically robust and electrically reliable so as to be operable even under harsh conditions.

Manufacturing electrically conductive connection structures of a component carrier in a simple way and with high precision is still difficult, in particular when embedding a component.

It is an object of the invention to form a component carrier with embedded component and electrically conductive structures which can be manufactured in a simple way and with high precision.

In order to achieve the object defined above, a component carrier and a method of manufacturing a component carrier according to the independent claims are provided.

According to an exemplary embodiment, a component carrier is provided which comprises a stack comprising at least one electrically conductive layer structure and at least one electrically insulating layer structure, wherein the at least one electrically insulating layer structure comprises at least one design layer structure having a stamped surface profile, and a component being embedded in the stack and being at least partially covered by the at least one design layer structure (in particular so that the embedded component shares a common connection surface with at least one of the at least one design layer structure or is in direct physical contact with at least one of the at least one design layer structure).

According to another exemplary embodiment, a method of manufacturing a component carrier is provided, wherein the method comprises forming a stack comprising at least one electrically conductive layer structure and at least one electrically insulating layer structure, stamping a surface profile in at least one design layer structure of the at least one electrically insulating layer structure, and embedding a component in the stack so that the component is at least partially covered by the at least one design layer structure.

In the context of the present application, the term "component carrier" may particularly denote any support structure which is capable of accommodating one or more components thereon and/or therein for providing mechanical support and/or electrical connectivity. In other words, a component carrier may be configured as a mechanical and/or electronic carrier for components. In particular, a component carrier may be one of a printed circuit board, an interposer, and an IC (integrated circuit) substrate. A component carrier may also be a hybrid board combining different ones of the above mentioned types of component carriers.

In the context of the present application, the term "stack" may particularly denote an arrangement of multiple planar layer structures which are mounted in parallel on top of one another.

In the context of the present application, the term "layer structure" may particularly denote a continuous layer, a patterned layer or a plurality of nonconsecutive islands within a common plane.

In the context of the present application, the term "design layer" may denote a layer being flexibly processable for designing substantially any desired surface profile extending therein and/or therethrough. Thus, any desired wiring design may be translated into a corresponding surface profile of the design layer so that filling created indentations in the design layer with electrically conductive material may lead to the predefined wiring design. Preferably, the design layer may be an initially at least partially uncured dielectric which may be cured during and/or after forming a predefined surface profile therein. The surface profile may then be rendered permanent. Hence, the design layer may be deformable before curing and may be non-deformable after curing. Preferably, the design layer may be made of a Nanoimprint Lithography (NIL) material. The design layer may or may not form part of a readily manufactured component carrier. Preferably, one or more indentations in the design layer structure may have different horizontal and/or vertical extensions. Alternatively, they may be the same.

In the context of the present application, the term "stamping a surface profile in the design layer" may denote the process of imprinting or embossing a predefined surface pattern in the design layer. For instance, this may be accomplished by pressing a working mold (or working stamp) in the (in particular still) deformable design layer or by guiding a working mold along the (in particular still) deformable design layer. Such a working mold may have an inverse surface profile in comparison with the surface profile of the design layer being processed. During a development and manufacturing process, first a master mold may be manufactured, for example by gray scale lithography. Then the master mold may be replicated by stamping several times into a transparent silicone material or the like, and a master working mold may be generated. Finally, working molds may be made by copying the master working mold. The working molds may be used during mass production and imprinted on panel surface.

In the context of the present application, the term "stamped surface profile" may denote a surface profile having a characteristic structure resulting from a stamping process executed by pressing a work mold into the design layer. In view of this manufacturing process, the stamped surface profile has a lower roughness, steeper sidewalls and other pattern characteristic than obtainable by etching-based or laser-based patterning processes. Said characteristics of a stamped surface profile are disclosed herein.

In the context of the present application, the term "component" may particularly denote an inlay, for instance fulfilling an electronic and/or a thermal task. For instance, an electronic component may be a semiconductor chip comprising a semiconductor material, in particular as a primary or basic material. The semiconductor material may for instance be a type IV semiconductor such as silicon or germanium, or may be a type III-V semiconductor material such as gallium arsenide. In particular, the semiconductor component may be a semiconductor chip such as a naked die or a molded die.

In the context of the present application, the term "embedded component" may denote a component being placed at least partially inside of a stack (rather than being surface mounted on a main surface of the stack). For example, an embedded component may be inserted in a through hole, a blind hole or a cavity of the stack. Both main surfaces of the embedded component may be located inside of the stack. Alternatively, one or both main surfaces of the embedded component may extend vertically beyond a respective main surface of the stack. However, at least part of the embedded component should be located inside of the stack.

In the context of the present application, the term "main surface" of a body may particularly denote one of two largest opposing surfaces of the body. The main surfaces may be connected by circumferential side walls. The thickness of a body, such as a stack, may be defined by the distance between the two opposing main surfaces.

According to an exemplary embodiment of the invention, a component carrier (such as a printed circuit board, PCB) with a (preferably laminated) layer stack is provided, the latter having one or more design layer structures with a stamped surface profile (preferably may be made of a Nanoimprint Lithography (NIL) material). At least one component (such as a semiconductor chip) may be embedded in the stack and may be in direct physical contact with the design layer structure. Advantageously, such a component carrier may be manufactured with high spatial accuracy thanks to the definition of a trace or wiring structure and/or of vertical through connections by the design layer structure with its stamped surface profile. As a result, even tiny electronic components with high number of input/output pads may be reliably connected inside of the component carrier. This may lead to a highly compact component carrier with embedded component(s) and excellent electric reliability. For example, embedding a component in a NIL dielectric may provide a high accuracy of formed electric connection structures as well as a small amount of processing stages. Furthermore, pads and traces may be manufactured in a common process and with high surface smoothness, which may be advantageous in particular for high-frequency applications.

In the following, further exemplary embodiments of the component carrier and the method will be explained.

In an embodiment, electrically conductive traces of the at least one electrically conductive layer structure delimited by the at least one design layer structure have a roughness Ra of less than 100 nm, in particular less than 50 nm. Ra denotes the arithmetic mean value of all distances of a profile from a centerline. For instance, the measurement or determination of roughness Ra may be carried out according to DIN EN ISO 4287:2010. The mentioned roughness values may lead to a low loss transmission of radiofrequency signals through the wiring structure(s), since no excessive surface roughness deteriorates signal propagation under consideration of the skin effect. According to the skin effect, an electric signal with a high-frequency, for instance in the gigahertz range, does not propagate over an entire cross-section of a conductor, but propagates substantially only within a skin-like surface portion thereof. This may conventionally cause significant signal losses with rough surfaces. Without wishing to be bound to a specific theory, it is presently believed that such signal losses may result from an additional electric resistance or impedance which the traveling radiofrequency signal suffers as a consequence of a rough surface. Advantageously, such signal losses can be prevented or at least strongly suppressed when ensuring a low roughness of electrically conductive wiring structures of a component carrier as a result of the formation of indentations in a design layer by stamping.

In an embodiment, vertical through connections of the at least one electrically conductive layer structure delimited by the at least one design layer structure have a depth-to-diameter ratio of larger than 1, in particular of larger than 1.5. By defining vertical through connections by stamping rather than by laser drilling or mechanically drilling, very high aspect ratios of the vertical through connections may be obtained. This may simplify the manufacturing process and may increase electric reliability.

In an embodiment, the component comprises at least one pad being oriented face-up and/or face-down. A component being oriented face-up may denote a component having at least one pad on an upper main surface thereof (optionally with or without at least one pad on a lower main surface thereof). A component being oriented face-down may denote a component having at least one pad on a lower main surface thereof (optionally with or without at least one pad on an upper main surface thereof). When the component has one or more pads oriented face-up, electric contacts to the component may be created by a subsequent deposition and stamping of a design layer from the top side of the component. Furthermore, face-up pads may be used as alignment marks as well.

In an embodiment, at least one surface portion of one or more connection pads of the component is in contact with the at least one design layer structure. The rest of the component may be not in direct contact with the design layer structure.

In an embodiment, at least a part of one vertical sidewall of the embedded component is covered by the at least one design layer structure. In particular, at least five sidewalls of the embedded component may be at least partially covered by the at least one design layer structure. For example, one of said five sidewalls may comprise at least one connection pad. An exception may be a lower main surface of the embedded component which may be mounted on a connection medium, such as a solder or a sinter paste.

In an embodiment, a first portion, in particular a bottom portion, of a dielectric surrounding of the embedded component is formed by a non-stampable dielectric, in particular a resin with reinforcing particles or a resin without reinforcing particles, and a second portion, in particular a top portion, of the dielectric surrounding is formed by the at least one design layer structure. Correspondingly, the method may comprise forming a first portion, in particular a bottom portion, of a dielectric surrounding of the embedded component by a non-stampable dielectric, in particular a resin with reinforcing particles or a resin without reinforcing particles, and forming a second portion, in particular a top portion, of the dielectric surrounding by the at least one design layer structure. For example, a first portion of the embedded component may be in direct physical contact with a standard component carrier dielectric comprising a resin (such as epoxy resin), optionally comprising reinforcing particles (such as glass spheres or glass fibers). Moreover, a second portion of the embedded component may be in direct physical contact with dielectric material of the design layer having a stamped surface profile. Advantageously, such a manufacturing architecture may use standard PCB processes for part of the surrounding of the embedded component, whereas another part of the surrounding may be formed by NIL material. This may keep the overall manufacturing effort reasonable, while ensuring a fine line wiring where needed.

In another embodiment, an entire dielectric surrounding of the embedded component may be formed by the at least one design layer structure. By completely surrounding the embedded component with a Nanoimprint Lithography (NIL) dielectric, a homogeneous dielectric shell fully circumferentially covers the embedded component (in particular together with metallic material). However, no non-NIL dielectric will directly cover the embedded component in the described embodiment. With such a homogeneous dielectric surrounding, no noteworthy CTE (coefficient of thermal expansion) mismatch occurs around the component which increases the thermal reliability of the component carrier.

In an embodiment, forming the entire dielectric surrounding of the embedded component by the at least one design layer structure is carried out by forming and stamping a first design layer structure at least partially below the component, and forming and stamping a second design layer structure at least partially above the component. Hence, the electronic component may be mounted on the first design layer structure after its formation, stamping and filling with metal. Thereafter, the second design layer structure may be formed, stamped and filled with metal on top of the first design layer structure and the component to thereby embed the latter. Even more than two design layers may be formed for providing the dielectric part of the stack in which the electronic component is embedded.

In an embodiment, the embedded component is mounted on at least one of the at least one electrically conductive layer structure by a connection medium, in particular sinter material, solder, or glue. For example, it is possible that the embedded component may be assembled to the stack by thermocompression bonding or hybrid bonding.

In an embodiment, the at least one design layer structure has at least one indentation positioned lateral to the embedded component. Such an indentation may be defined by stamping and may have a very high depth to diameter ratio, for instance a depth to diameter ratio of more than 1. For example, a single (for example tapering) indentation arranged laterally with respect to the embedded component may extend from above the embedded component to below the embedded component. Such an indentation may bridge a vertical range larger than the vertical extension of the component.

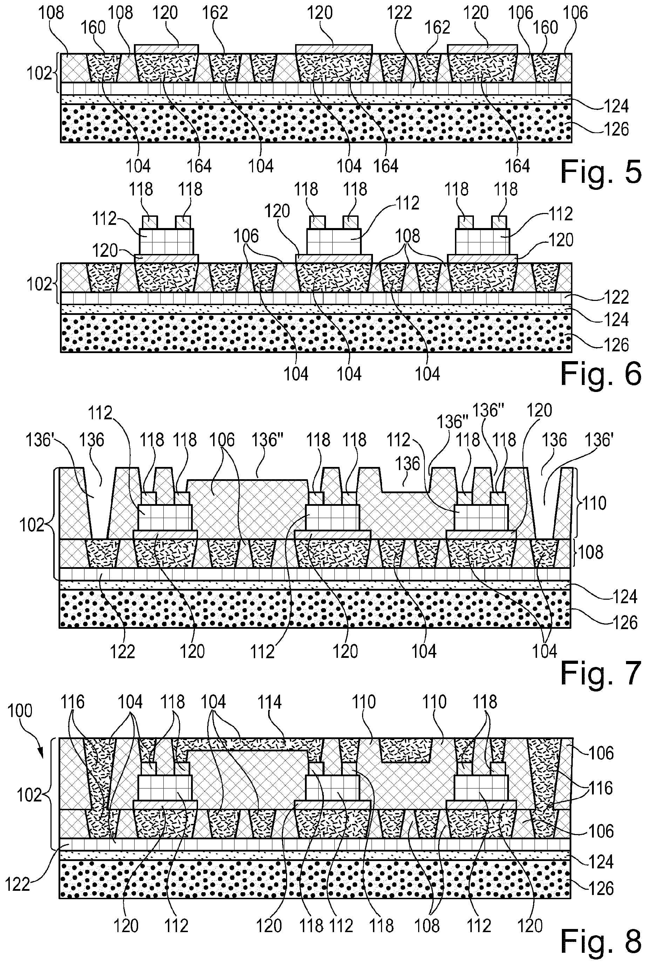

In an embodiment, the method comprises forming at least one of the at least one design layer structure on a metal base, stamping the at least one of the at least one design layer structure on the metal base to thereby expose portions of the metal base, and plating at least part of the at least one electrically conductive layer structure on or above the exposed portions of the metal base. Advantageously, exposed portions of the metal base may be used as an electrode during electroplating (for example galvanic plating) for filling indentations of this stamped design layer with electrically conductive material. For this purpose, the stamping process may form at least one indentation extending entirely through the design layer to thereby expose the metal base. In an embodiment, a component may be placed on said metal base, and the metal base may be used as a heat sink. For instance in Figure 6 to Figure 8, the respective embedded component is located on and above a metal which is used as a heat sink. If components have pads on both opposing main surfaces, a metallic connection to such pads may be used as heat sink plus signal and/or electrical power transfer.

In an embodiment, the plating comprises electroplating. Electroplating may denote processes that produce a metal coating on a solid substrate through the reduction of cations of that metal by a direct electric current. In particular, electroplating may be embodied by galvanic plating. However, it is also possible that the plating process comprises an electroless plating stage, in particular for preparing subsequent electroplating. By plating and preferably electroplating, indentations formed by a stamped profile of the design layer may be filled with metal for forming electrically conductive structures, such as a wiring pattern and/or vertical through connections.

In an embodiment, the method comprises arranging the component with at least one pad arranged face-up. Advantageously, the at least one pad arranged face-up may be used as alignment mark for subsequent processing. Consequently, the at least one pad may fulfill a double function, i.e. electrically connecting the embedded electronic component and contributing to alignment accuracy.

In an embodiment, the method comprises forming a metal base on a release layer which is arranged, in turn, on a temporary carrier, forming at least one of the at least one design layer structure on the metal base, and sequentially removing the temporary carrier at the release layer prior to completing manufacture of the component carrier. For example, such a temporary carrier may be a support plate, for instance made of glass, steel or FR4. Preferably, the mentioned release layer may have non-adhesive or poorly adhesive properties. Examples for materials of the release layer are a release ink, polytetrafluoroethylene, polyimide, a waxy material or a suitable varnish. This allows detaching the readily manufactured component carrier or a preform thereof from the temporary carrier at the end of a manufacturing process.

In another embodiment, the method comprises forming the design layer on the carrier, not necessarily comprising a release layer. As mentioned, the carrier may be a temporary carrier which may be removed at the end of the manufacturing process. However, alternatively, the carrier may form part of the component carrier, in which case the carrier is not removed from the design layer. Such a carrier may also be - in particular directly - connected to the design layer (i.e. may also be provided without release layer in between). Such a carrier may be an insulating layer (e.g. comprising resin) with or without an (in particular patterned) electrically conductive wiring thereon. This electrically conductive wiring allow a direct electric connection from the carrier to the metallic base structure. A permanent carrier forming part of a component carrier according to an exemplary embodiment of the invention may be made preferably of glass. It is specifically preferred that such a component carrier with glass carrier is configured as interposer. Hence, in particular when glass is used as insulating layer or insulating carrier, it may be advantageous that an additive build-up with NIL is used for manufacturing an interposer. As interposers can be advantageously made with glass as insulating material, the carrier structure (or further build-up structure) can be advantageously used for a NIL process.

In an embodiment, a cleaning process may be optionally carried out after stamping a design layer structure and before plating material in indentations of the stamped design layer structure. Such a cleaning process may remove residues of the design layer structure, for instance on a metallic base structure exposed by indentations of the design layer structure, and may thereby ensure a high efficiency of the plating process.

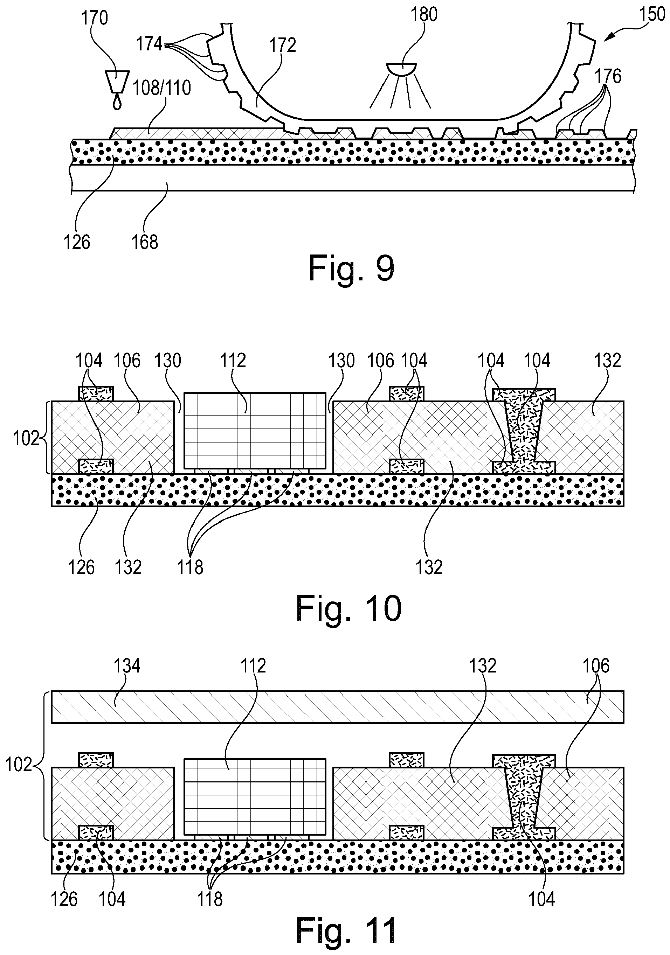

In an embodiment, the method comprises providing a core of the stack with a through hole, closing the through hole by attaching a temporary carrier to a bottom of the core, mounting the component in the through hole on the temporary carrier, subsequently partially surrounding the component by a dielectric of the at least one electrically insulating layer structure, subsequently removing the temporary carrier, forming the at least one design layer structure at the core and at the component, stamping the surface profile in the at least one design layer structure for exposing at least one pad of the component, and forming at least one of the at least one electrically conductive layer structure in the stamped at least one design layer structure for contacting the exposed at least one pad. Such a manufacturing process is described referring to Figure 10 to Figure 14. By the described process, a simple processing may be combined with a fine line pattern on an electric contact surface of the embedded electronic component.

In an embodiment, stamping the surface profile in the at least one design layer structure comprises forming tapering indentations in the at least one design layer structure. Correspondingly, a created electroplating structure in a respective indentation may have tapering sidewalls. Advantageously, stamping of the design layer may be accomplished by a working mold (for instance a glass plate with a surface profile on one main surface) deforming the design layer for forming a surface profile therein being inverse to a surface profile of the working mold. After the stamping process, the working mold may be removed again from the design layer. Under undesired circumstances, it may be difficult to remove the master mold from the design layer after stamping without damaging the formed surface profile due to adhesion between design layer and working mold. However, it has been surprisingly found that providing the working mold with tapering protrusions corresponding to inverse tapering indentations in the design layer significantly reduces the tendency of the working mold of adhering to the profiled design layer when removing the working mold after stamping. Furthermore, such a tapering geometry may also reduce the risk of defects in the processed design layer.

In an embodiment, stamping the surface profile in the at least one design layer structure comprises forming indentations of different depth and/or different length in the at least one design layer structure. Correspondingly, an electrically conductive layer structure and/or a metallic base structure may form or may form part of sub-structures of different depth and/or different length in the design layer. For instance, at least one first indentation formed in the design layer may extend through the entire design layer and may thereby form a through hole. Such a through hole may, when filled with plated metal, form an electrically conductive through connection (such as a via) in the readily manufactured component carrier. For example, at least one second indentation formed in the design layer may extend through only part of the thickness of the design layer and may thereby form a blind hole. Such a blind hole may, when filled with plated metal, form a horizontally extending trace in the readily manufactured component carrier. Advantageously, a horizontal trace may have a larger length than a vertical through connection. With the described manufacturing architecture, a design layer may be formed with two or more indentations extending up to different vertical positions and/or extending along different horizontal extensions. Consequently, even complex horizontal and/or vertical wiring structures may be defined precisely and in a simple way. In particular, this may also make it possible to create three-dimensionally curved wiring structures.

In an embodiment, stamping the surface profile in the at least one design layer structure comprises forming trace-shaped and/or via-shaped and/or combined trace-and-via-shaped indentations in the at least one design layer structure. Accordingly, the electroplating structure and the metallic base structure (optionally in combination with a portion of a seed layer) may form or form part of trace-type and/or via-type sub-structures, or a combination thereof. Highly advantageously, both electrically conductive traces and vertical through connections may be formed simultaneously and thereby quickly with miniature dimensions in a common design layer.

In an embodiment, the method comprises curing the at least one design layer structure, in particular simultaneously stamping and curing the at least one design layer structure. During the NIL process, the stamping and curing may occur simultaneously (once one stamps, one may expose the structure, to prevent the resist from flowing apart). During stamping, the design layer is preferably freely deformable by a mechanical impact, which allows to stamp indentations in the design layer by a working mold in accordance with a desired wiring pattern. After stamping, the created surface profile shall remain permanent at least in certain embodiments, i.e. the processed design layer shall be converted into a non-deformable state. This can be accomplished by curing the design layer. For instance, when the design layer comprises at least partly uncured resin, curing may be accomplished by the application of thermal energy and/or mechanical pressure, which may trigger curing processes such as cross-linking, polymerization, etc. Supply of curing energy may be accomplished by irradiation of the design layer with electromagnetic radiation of an electromagnetic radiation source, preferably ultraviolet (UV) radiation. Highly advantageously, curing of the design layer may be accomplished during stamping and further advantageously by a working mold itself. For instance, a light source (such as a UV lamp) may be integrated in the working mold so that light-triggered (in particular UV-triggered) curing may be carried out during the process of stamping.

In an embodiment, the method comprises forming a build-up based on the profiled design layer. Preferably, the build-up comprises at least one laminated printed circuit board-type layer stack. Formation of such a build-up may involve processes such as laminating additional electrically conductive layer structures (for example copper foils) and/or electrically insulating layer structures (for instance prepreg sheets) to one or both opposing main surfaces of the separated profiled and metallized design layer. However, galvanic plating of copper layers may be preferred in certain embodiments. The readily manufactured component carrier may then be a hybrid of the profiled and metallized design layer and the PCB-type stack(s) of laminated layer structures.

In an embodiment, the method comprises removing, in particular by etching, residues of the design layer in at least one bottom region of the indentations of the profiled design layer. In particular when intending to form through holes extending through the entire design layer, it may happen that, after the stamping, a thin skin of design layer material remains at the bottom of the indentation which shall form a through hole. During forming a seed layer, such an artifact may lead to an undesired electric isolation by the remaining dielectric skin. In order to avoid such phenomena, it may be advantageous to treat the stamped design layer (in particular prior to seed layer formation) by an etching process to remove residues from indentations of the design layer after stamping.

In an embodiment, the design layer may remain part of the readily manufactured component carrier, i.e. may be a permanent design layer. It may then be possible to adjust the material properties of the design layer so that a component carrier with high electric, mechanical and/or thermal reliability is obtained. This may allow to suppress undesired phenomena such as warpage, delamination, and mechanical and/or thermal stress. For example, this may be accomplished by configuring the design layer with material properties as described herein.

Next, advantageous material properties of the design layer structure will be summarized. The design layer structure may have one, any combination of at least two, or all of the properties mentioned in the following:
The glass temperature Tg of material (in particular of resin material) of the design layer structure may be in a range from 120°C to 260°C. This may avoid undesired phase transitions of the design layer during processing and/or using the component carrier.

A value of the Young modulus below the glass temperature Tg may be in a range from 1000 MPa to 15000 MPa. A value of the Young modulus above the glass temperature Tg may be in a range from 60 MPa to 800 MPa. These properties may ensure that the material of the design layer structure is sufficiently mechanically strong for enabling a precise design of electrically conductive traces, vertical through connections, etc. in the design layer structure. At the same time, these properties may ensure that the material of the design layer structure has a sufficient elasticity to buffer thermal and/or mechanical stress.

A value of the coefficient of thermal expansion (CTE) below the glass temperature Tg may be in a range from 10 ppm/K to 40 ppm/K. A value of the coefficient of thermal expansion above the glass temperature Tg may be in a range from 50 ppm/K to 100 ppm/K. These values may suppress thermal stress in an interior of the component carrier.

A value of the fracture strain below the glass temperature Tg may be at least 2%. This may lead to advantageous mechanical properties of the design layer structure and a correspondingly manufactured component carrier.

A value of the chemical shrinkage may be not more than 3%. Consequently, shrinkage-based curing stress in an interior of the component carrier may be avoided.

A Dk value of the material of the design layer structure (in particular of resin thereof) may be not more than 3. A Df value of the material of the design layer structure (in particular of resin thereof) may be not more than 0.003. As a result, an obtained component carrier may have excellent properties in terms of high-frequency behavior.

A number of press cycles which the material of the design layer structure may withstand may be in a range from 1 to 10. A number of reflow tests which the material of the design layer structure may withstand may be at least 6. This may allow to manufacture a component carrier using a design layer structure with a stack thickness being selectable over a sufficiently broad range.

The material of the design layer structure may be characterized by a peel test on copper of at least 600 N/m. Moisture absorption by the material of the design layer structure may be not more than 0.1%. A desmear rate of the material of the design layer structure may be at least 0.006 g/min. The material of the design layer structure may be characterized by a UL listing (in accordance with the industrial standard IEC/DIN EN 60695-11-10 and -20 in the latest version being in force at the priority date of the present application) of V1 to V0 (which may ensure safety against flammability). The mentioned material properties may simplify processing of the design layer structure.

Advantageously, the design layer structure may comprise resin and (preferably inorganic) fillers (such as filler particles). Optionally, one or more additives may be included in the material of the design layer structure for functionalizing the latter.

Preferably, the inorganic fillers may be in a crystalline state. Additionally and/or alternatively, the inorganic fillers may be in an amorphous state. Furthermore, the inorganic fillers may be encapsulated. An average size (to be calculated according to an arithmetic average) of the inorganic fillers may be smaller than 0.1 µm. For example, the inorganic fillers may be made of fused silicon oxide. The inorganic filler particles may be plasma etchable. A weight percentage of the filler particles, in relation to an entire weight of the material of the design layer, may be up to 95 weight %.

A further constituent of the design layer structure may be resin. Epoxy resin, poly(p-phenylene ether) (PPE), bisbenzocyclobutene (BCB), polybenzoxabenzole (PBO), and/or polyimide may be used. It is also possible to use phenolic resin, acrylic resin, and their halogenated or modified versions as constituent of the design layer structure. In the context of this document, the term "halogenated" may describe a substance and/or material, which comprises at least one halogen atom, for instance fluorine, chlorine, bromine or iodine. However, a chlorine content of the resin may be preferably below 30 ppm, in one embodiment. Advantageously, no salt formation should occur during the processing of the resin. Moreover, a high cross-linking capability of the resin may be advantageous. A low porosity may be preferred to avoid undesired phenomena such as cracks, migration, etc.

In an embodiment, the component carrier comprises at least one further component, which may be a surface mounted component or a further embedded component. For example, such a further component may be electrically connected to the electrically conductive layer structures in the design layer structure. Such a further component, for instance an electronic component such as a semiconductor chip, may be surface mounted on the design layer structure with integrated wiring structure or may also be embedded therein. In particular, the at least one further component may be located in the same layer (in particular at the same vertical height of the layer stack) as the aforementioned component. Furthermore, the further component may be in direct or indirect physical and/or electrical connection with the component.

In an embodiment, the component carrier further comprises at least one further design layer structure in which a further surface profile is stamped. Hence, a plurality of design layer structures, each with integrated wiring structure(s), may be vertically stacked to form more complex three-dimensional arrangements of wiring structures. Hence, this may make it possible to create even sophisticated or complex wiring architectures in the component carrier in a straightforward way. Working molds of different stacked design layer structures may be the same or may be different.

Specifically, the design layer material may be configured for being used for prepolymer composition, characterized in that it may be used for continuous structuring and in-situ electromagnetic radiation-based curing in an NIL imprint process. A corresponding NIL material may stay in a final build-up. Preferably, this may be accomplished in a roll-to-plate process (which has the advantage of being very fast) and/or a plate-to-plate process (which may provide a better alignment accuracy). In particular, electromagnetic radiation-based curing may be carried out by electromagnetic radiation in a wavelength range from 10 nm to 700 nm, in particular from 100 nm to 450 nm. Preferably, the electromagnetic radiation used for curing may be in the ultraviolet (UV) range. Additionally or alternatively to an electromagnetic radiation-based curing, also thermal curing is possible.

Specifically, the design layer material may be configured for being used as an etching mask during an etching process for structuring a surface.

According to a further exemplary embodiment the design layer structure has an adhesion of more than 600 N/m. Adhesion is the tendency of dissimilar particles or surfaces to cling to one another. The forces that cause adhesion may be intermolecular forces responsible for the function of various kinds of stickers and adhesive sheet fall into the categories of chemical adhesion, dispersive adhesion, and diffusive adhesion.

According to a further exemplary embodiment the design layer structure comprises temperature resistance between 200°C and 300 °C, in particular 230°C to 260°C. The design layer structure may be in particular a cured cross-linked resist material having the temperature resistance between 230°C to 260°C. The higher the cross-linking, the higher the modulus - depending on used base oligomers and/or polymers.

According to a further exemplary embodiment, the design layer structure comprises material of a flame retardancy class 4 (FR4). FR4 may be a composite material composed of woven fiberglass cloth with an epoxy resin binder that is flame resistant (self-extinguishing). FR4 glass epoxy is a highpressure thermoset plastic laminate grade with good strength to weight ratios. With near zero water absorption, FR4 is used as an electrical insulator possessing considerable mechanical strength.

According to a further exemplary embodiment, the design layer structure comprises material having a glass-transition temperature between 120°C and 200°C, in particular between 135°C and 170°C.

According to a further exemplary embodiment, the design layer structure has a (Young) modulus below a glass-transition temperature (in the fully cured stage) of 1000 MPa to 14000MPa, in particular 5000 MPa to 13000 MPa.

According to a further exemplary embodiment, the design layer structure has a (Young) modulus above a glass-transition temperature (i.e. in a reflow state) of 60 MPa to 800, in particular 100 MPa to 600 MPa. The glass-liquid transition is the gradual and reversible transition in amorphous materials (or in amorphous regions within semicrystalline materials) from a hard and relatively brittle glassy state into a viscous or rubbery state as the temperature is increased. An amorphous solid that exhibits a glass transition is called a glass. The reverse transition, achieved by supercooling a viscous liquid into the glass state, is called vitrification. The glass-transition temperature Tg of a material characterizes the range of temperatures over which this glass transition occurs. It may be lower than the melting temperature of (for example crystalline) fillers.

These properties may ensure that the material of the design layer structure is sufficiently mechanically strong for enabling a precise design of electrically conductive traces, vertical through connections, etc. in the design layer structure. At the same time, these properties may ensure that the material of the design layer structure has a sufficient elasticity to buffer thermal and/or mechanical stress.

According to a further exemplary embodiment, the design layer structure has a thermal expansion coefficient below a glass-transition temperature of 10 ppm/K to 40 ppm/K, in particular 20 ppm/K to 40 ppm/K. These values may suppress thermal stress in an interior of the component carrier.

According to a further exemplary embodiment, the design layer structure has a thermal expansion coefficient above a glass-transition temperature of 50 ppm/K to 100 ppm/K, in particular 60 ppm/K to 85 ppm/K. These values may suppress thermal stress in an interior of the component carrier. The higher the value of the thermal expansion coefficient (CTE) above Tg, the higher the reliability issue. The design layer structure may comprise nonwoven glass fibers such that thermal expansion occurs in all directions. The thermal expansion coefficient is also driven by the amount of fillers. The thermal expansion coefficient decreases if the amount of filler increases. The design layer structure may have a filler content of more than 50%, for example 80% filler.

According to a further exemplary embodiment, the design layer structure is formed with a fracture strain below a glass-transition temperature of is 2%. This may lead to advantageous mechanical properties of the design layer structure and a correspondingly manufactured component carrier.

According to a further exemplary embodiment, the design layer structure is formed with a chemical shrinkage below 3 %. Consequently, shrinkage-based curing stress in an interior of the component carrier may be avoided.

According to a further exemplary embodiment, the design layer structure is formed with a moisture absorption below 0,1%.

According to a further exemplary embodiment, the desmear rate is below 0,006 g/min.

A Dk value of the material of the design layer structure (in particular of resin thereof) may be not more than 3, specifically for high frequency applications. A Df value of the material of the design layer structure (in particular of resin thereof) may be not more than 0.003, specifically for high frequency applications. As a result, an obtained component carrier may have excellent properties in terms of high-frequency behavior. If the filler content increases, the values for Dk and Df increases as well.

A number of press cycles which the material of the design layer structure may withstand may be in a range from 1 to 10. A number of reflow tests which the material of the design layer structure may withstand may be at least 6. This may allow to manufacture a component carrier using a design layer structure with a stack thickness being selectable over a sufficiently broad range. The material of the design layer structure may be characterized by a peel test on copper of at least 600 N/m. A press cycle of the design layer structure may withstand from 6 up to 10 times.

A desmear rate of the material of the design layer structure may be at least 0.006 g/min. The material of the design layer structure may be characterized by a UL listing (in accordance with the industrial standard IEC/DIN EN 60695-11-10 and -20 in the latest version being in force at the priority date of the present application) of V1 to V0 (which may ensure safety against flammability). The mentioned material properties may simplify processing of the design layer.

According to a further exemplary embodiment, the design layer structure comprises a fully cured polymer based on at least one of the following group comprising epoxies, acrylates, polyphenylenether, polyimide, polyamide and polyetheretherketon, poly(p-phenylene ether) (PPE), bisbenzocyclobutene (BCB), and/or polybenzoxabenzole (PBO).

Specifically, a combination of the oligomers listed above may be used for a (specifically permanent) design layer (i.e. an UV-NIL resist). For example, a combination of BCB, PPE and SU8 loaded can be used with a high amount of more than 50 % of encapsulated inorganic, round shape SiO2 nanofillers and a halogen-free material. Different kinds of encapsulated nanofillers may be used. Further examples for suitable filler materials are boron nitride (BN) or aluminum nitride (AIN).

For example BCB (Divinylsiloxane-bis-benzocyclobutene (DVS-bis-BCB, or BCB), e.g. CYCLOTENE^{™} DuPont Series advanced electronic resins) are photopolymers. The polymers are derived from B-staged bisbenzocyclobutene (BCB) chemistry.

For example, PPE (e.g. Sabic NORYL SA9000 resin) is a modified, low molecular weight, bi-functional oligomer based on polyphenylene ether (PPE) with vinyl end-groups (used in Megtron 6 &7 Materials).

For example, SU-8 (e.g. Kayaku Advanced Materials SU-8) is a high contrast, epoxy-based photoresist designed for micromachining and other microelectronic applications.

A chloride content of the resin may be below 30 ppm. Specifically, the design layer structure may be almost free of halogens (e.g. less than 1 ppm) which are ionic and not bonded with a polymer. The halogens may be washed out with multiple water wash steps.

Advantageously, no salt formation should occur during the processing of the resin. Moreover, a high cross-linking capability of the resin may be advantageous. A low porosity may be preferred to avoid undesired phenomena such as cracks, migration, etc.

According to a further exemplary embodiment, the design layer structure comprises polymer- or oligomer-based building blocks, wherein at least one of the building blocks is based on one of the above-mentioned polymers.

According to a further exemplary embodiment, the design layer structure at least one of the building-blocks has at least one functional group covalently bond to another one of the least one building block. The covalently bound functional group is responsible for the cross-linking connection.

According to a further exemplary embodiment, the at least one functional group is selected from one of the group comprising a thiol group selected from the group of 3-mercaptopropionates, 3-mercaptoacetates, thioglycolates and alkylthiols, and/or a double bond selected from the group of acrylates, methyl acrylates, vinyl ethers, allyl ethers, propenyl ethers, alkenes, dienes, unsaturated esters and allyl triazines, allyl isocyanates and N-vinyl amides.

According to a further exemplary embodiment, the design layer structure comprises a prepolymer having at least one photoinitiator, contained in an amount of 0.1 wt.% to 10 wt.%, in particular 0.5 wt.% to 5 wt.%.

According to a further exemplary embodiment, the design layer structure is in particular a fully cured resin, wherein the design layer further comprises filler particles such as in an amount of 1 wt.% to 10 wt.%, in particular 1 wt.% to 3 wt.%.

According to a further exemplary embodiment, the filler particles comprise inorganic fillers, wherein the inorganic fillers are in a crystalline and/or amorphous state and in particular encapsulated. The inorganic fillers may be nanofillers which can be coated to avoid agglomeration and reduce thixotropy. Porous fillers may have lower Dk because of air but they can absorb chemistry. Therefore porous fillers have a hydrophobic silane coating as it is the case in Rogers 3000 materials, at the same time mixing of fillers in the resin matrix is easier. Halogenated organics, hydrophobic polymers and covalent bonded halogen can be used for the fillers so that a high flame retardant can be achieved. The design layer structure may comprise high inorganic filler with an aromatic content. The inorganic fillers may have a round smooth shape or a needle shape. Also shapes comprising edges are possible, for example cubes, pyramids, etc.

According to a further exemplary embodiment the filler particles comprise a size (e.g. an average size to be calculated according to an arithmetic average) of less than 0,1 µm.

According to a further exemplary embodiment, the filler particles comprise Talcum (i.e. a layered silicate), Zeolite, BN, AIN and/or fused SiO₂. SiO₂ or Zeolite nanofiller usually agglomerate but with coating this agglomeration can be reduced and also tixotrophy may be reduced.

According to a further exemplary embodiment, the filler particles are of plasma etchable material.

According to a further exemplary embodiment, the design layer structure comprises less than 95% (weight percentage) filler particles, in particular 80% to 95% filler particles, in relation to an entire weight of the material of the design layer. More filler particles cause less shrinking of ink during electromagnetic radiation-based (for example UV-based) and/or thermal curing, for example, and causes better CTE at the same time. Furthermore, better flame retardant is achieved at the same time.

In an embodiment, the component carrier comprises a stack of at least one electrically insulating layer structure and at least one electrically conductive layer structure. For example, the component carrier may be a laminate of the mentioned electrically insulating layer structure(s) and electrically conductive layer structure(s), in particular formed by applying mechanical pressure and/or thermal energy. The mentioned stack may provide a plate-shaped component carrier capable of providing a large mounting surface for further components and being nevertheless very thin and compact.

In an embodiment, the component carrier is shaped as a plate. This contributes to the compact design, wherein the component carrier nevertheless provides a large basis for mounting components thereon. In particular a naked die as example for an electronic component can be surface mounted on a thin plate such as a printed circuit board.

In an embodiment, the component carrier is configured as one of the group consisting of a printed circuit board, a substrate (in particular an IC substrate), and an interposer.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole either connects the whole stack, (through-hole connections extending through several layers or the entire stack), or the filled hole connects at least two electrically conductive layers, called via. Similarly, optical interconnections can be formed through individual layers of the stack in order to receive an electro-optical circuit board (EOCB). A printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier. A substrate may be a, in relation to a PCB, comparably small component carrier onto which one or more components may be mounted and that may act as a connection medium between one or more chip(s) and a further PCB. For instance, a substrate may have substantially the same size as a component (in particular an electronic component) to be mounted thereon (for instance in case of a Chip Scale Package (CSP)). More specifically, a substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the substrate and can be used to provide electrical, thermal and/or mechanical connections of housed components or unhoused components (such as bare dies), particularly of IC chips, with a printed circuit board or intermediate printed circuit board. Thus, the term "substrate" also includes "IC substrates". A dielectric part of a substrate may be composed of resin with reinforcing particles (such as reinforcing spheres, in particular glass spheres).

The substrate or interposer may comprise or consist of at least a layer of glass, silicon (Si) and/or a photoimageable or dry-etchable organic material like epoxy-based build-up material (such as epoxy-based build-up film) or polymer compounds (which may or may not include photo- and/or thermosensitive molecules) like polyimide or polybenzoxazole.

In an embodiment, the at least one electrically insulating layer structure comprises at least one of the group consisting of a resin or a polymer, such as epoxy resin, cyanate ester resin, benzocyclobutene resin, Melamine derivates, Polybenzoxabenzole (PBO), bismaleimide-triazine resin, polyphenylene derivate (e.g. based on polyphenylenether, PPE), polyimide (PI), polyamide (PA), liquid crystal polymer (LCP), polytetrafluoroethylene (PTFE), Bisbenzocyclobutene (BCB) and/or a combination thereof. Reinforcing structures such as webs, fibers, spheres or other kinds of filler particles, for example made of glass (multilayer glass) in order to form a composite, could be used as well. A semi-cured resin in combination with a reinforcing agent, e.g. fibers impregnated with the above-mentioned resins is called prepreg. These prepregs are often named after their properties e.g. FR4 or FR5, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating structures.

In an embodiment, the at least one electrically conductive layer structure comprises at least one of the group consisting of copper, aluminum, nickel, silver, gold, palladium, tungsten and magnesium. Although copper is usually preferred, other materials or coated versions thereof are possible as well, in particular coated with supra-conductive material or conductive polymers, such as graphene or poly(3,4-ethylenedioxythiophene) (PEDOT), respectively.

The at least one component can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminium oxide (Al₂O₃) or aluminum nitride (AIN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (Ga₂O₃), indium gallium arsenide (InGaAs) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be surface mounted on the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be a IC substrate, an interposer or a further component carrier, for example in a board-in-board configuration. The component may be surface mounted on the component carrier. Moreover, also other components, in particular those which generate and emit electromagnetic radiation and/or are sensitive with regard to electromagnetic radiation propagating from an environment, may be used as component.

In an embodiment, the component carrier is a laminate-type component carrier. In such an embodiment, the component carrier is a compound of multiple layer structures which are stacked and connected together by applying a pressing force and/or heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or component carrier.

In particular, an electrically insulating solder resist may be applied to one or both opposing main surfaces of the layer stack or component carrier in terms of surface treatment. For instance, it is possible to form such a solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable. A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), gold (in particular hard gold), chemical tin, nickel-gold, nickel-palladium, etc.

The aspects defined above and further aspects of the invention are apparent from the examples of embodiment to be described hereinafter and are explained with reference to these examples of embodiment.

Figure 1 to Figure 8 illustrate cross-sectional views of structures obtained during carrying out a method of manufacturing a component carrier according to an exemplary embodiment of the invention, shown in Figure 8.

Figure 9 shows a device for stamping a surface profile in a design layer using a working mold according to an exemplary embodiment.

Figure 10 to Figure 14 illustrate cross-sectional views of structures obtained during carrying out a method of manufacturing a component carrier according to an exemplary embodiment of the invention, shown in Figure 14.

Figure 15 to Figure 21 illustrate cross-sectional views of structures obtained during carrying out a method of manufacturing a component carrier according to an exemplary embodiment of the invention, shown in Figure 21.

The illustrations in the drawings are schematic. In different drawings, similar or identical elements are provided with the same reference signs.

Before referring to the drawings, exemplary embodiments will be described in further detail, some basic considerations will be summarized based on which exemplary embodiments of the invention have been developed.

According to an exemplary embodiment of the invention, a stamped design layer structure with corresponding surface profile may be used as a basis for embedding a component in a component carrier such as a printed circuit board (PCB) or an integrated circuit (IC) substrate. Using for example an NIL-type design layer structure for embedding an electronic component (such as a semiconductor chip) may allow to electrically connect the embedded component to electrically conductive structures formed in the stamped design layer with excellent spatial accuracy. Furthermore, a highly compact component carrier having an embedded component and having electrically conductive layer structures with high integration density may be provided.

More specifically, exemplary embodiments may provide an embedded multi-die interconnection semi-additive processing (SAP) Nanoimprint Lithography (NIL) process for manufacturing an IC substrate or another type of component carrier. Particularly preferred may be the implementation of a die-type electronic component with face-up pads and thermal bonding for die assembly. Advantageously, an SAP NIL process may be executed for the formation of vias and traces simultaneously for lines larger than 10 µm (but preferably for finest lines below 10 µm and preferably below 5 µm), and connection of small pitch components. Further advantageously, all geometries may be defined by a single common production stage. Furthermore, all said geometries may be created within a single common layer. For example, thicker copper traces formed in a processed NIL layer may function for thermal management and/or power supply, whereas finest copper traces may be used for signal transmission purposes. Advantageously, the described manufacturing architecture may allow to execute a fine line process for the production of electrically conductive structures with line space ratio L/S of 10 µm/10 µm, and below. In particular, exemplary embodiments may allow a selective protection via inking of highest copper pattern areas for supporting a selective galvanic copper plating process.

Exemplary applications of exemplary embodiments of the invention are fine line applications, mobile applications, IC substrates, etc.

In particular, exemplary embodiments may combine a thermal compression bonded chip with face-up placement, followed by an NIL (Nanoimprint Lithography) and an SAP (semi-additive processing) process for connecting chip pads and for plating of finest interconnection structures. What concerns the mentioned thermal compression bonding, this may be accomplished for example with a component surface made of metal by forming a metal-metal-connection. When the component is made of silicon, a die attach paste may be applied for assembly. In particular, the manufacturing effort for via formation may be reasonable, and an SAP-type mass production of finest lines may become possible. In particular, exemplary embodiments may provide finest lines for organic substrates. This may allow to avoid the provision of a silicon interposer.

Exemplary embodiments of the invention provide a PCB-type or IC substrate-type component carrier containing one or more embedded components (such as dies) and fine interconnection structures. Such a component carrier may be manufactured with low manufacturing effort. In particular, such a manufacturing process may comprise thermal compression bonding of different components in face-up direction on a (for example copper) metal structure. This may be followed by a Nanoimprint lithography process for the formation of a fine line pattern for interconnecting the embedded component inside of the component carrier. For the manufacturing of fine interconnection copper structures between the components, an SAP (semi-additive processing) copper plating process may be applied. Such a manufacturing process may render an efficient component carrier (in particular substrate) manufacturing process possible. Such a process may be executed without laser drilling to connect different components (in particular dies) to copper structures that can be applied in different layers of the component carrier.

According to an exemplary embodiment of the invention, an IC substrate or PCB production process is provided which is highly appropriate for a low-effort mass production of a component carrier with at least one or preferably a plurality of embedded semiconductor chip-type components. In such a manufacturing process, interconnections of the at least one embedded electronic component may be accomplished by a semi-additive processing Nanoimprint Lithography process (SAP NIL). In particular, such a process may include a face-up assembly of the electronic component and a thermal compression bonding process for connecting the component on a metallic (preferably copper) surface. This may be followed by an NIL imprinting process and semi-additive processing for defining an electrically conductive connection structure. After thermal bonding of the one or more electronic components to the substrate in a face-up orientation, the one or more electronic components can be embedded by a permanent NIL resist followed by an NIL imprinting process. Preferably, the same alignment marks on a copper foil may be used for a UV-Nanoimprint Lithography resist structuring process for manufacturing of fine interconnection structures as well as for the connection of the chip pads. However, also copper pads of a component being assembled for subsequent embedding may be used as alignment marks. The interconnection structures between the dies may be formed by a galvanic copper SAP process.

According to an exemplary embodiment, after the thermal diffusion bonding process of the different components on the metal foil and the NIL imprinting process, a metallic seed layer may be deposited on the exposed surface (and in particular on an exposed surface of indentations in a design layer structure) followed by metal traces and via filling. The thermal diffusion bonding process has the advantage that any movement or shifting of the component(s) may be avoided (whereas such a shifting may occur when forming a strong, sintered metallic bond). At the same time, an efficient heat transfer to the metallic substrate may be provided. By using the alignment marks from the metal foil for the alignment of the components and further using the alignment marks of the components for the NIL imprinting process, a high accuracy (for example better than 3 µm) may be achieved for the NIL imprinting process. High density copper interconnect structures as well as low density structures can be formed by a simple plating process, in particular using a modified semi-additive processing (mSAP) or semi-additive processing (SAP) approach. For a thermal sintering process, any thermal sintering process equipment can be used. Examples are diffusion soldering, or sintering with copper, tin, silver and/or composite sintering pastes being appropriate to connect the component pads surface (for example copper, aluminum and/or gold) on the copper foil surface to form a stable, mechanically robust connection with good electric conductivity. If a sinter paste is used, copper micro sinter paste and/or nano sinter paste or Cu-Sn-Ag sinter paste is or are preferred. For embedding the component(s), any resin or NIL resist with appropriate mechanical and thermal specifications can be used with a structured copper layer suitable for substrate and PCB manufacturing as well as for a pressing process. One advantage of the substrate or PCB manufacturing process of embodiments of the invention is that the thermally bonded components on the copper surface will not move during an NIL imprinting process when the NIL resist is in the liquid state. The NIL resist may fill the spaces between the components and, at the same time, may be used for structuring the fine lines and the vias to connect the chip pads. Preferably, there will be no cavities created either within the NIL resist and/or between the NIL resist and a surface of a different material, for example a metal trace, a component or a component connection pad, or a dielectric material.

In this way, a cut-out of a prepreg can be avoided. Additional processes such as laser drilling can be avoided as well. Due to the reduction of processes, the complexity of manufacturing may be reduced and an increased quality as well as an economic mass production route may become possible.

In one embodiment, the component being embedded at least partially in a stamped design layer structure comprises at least one metallic pad only at an upper main surface. This may simplify chip assembly on a metal base or the like. Alternatively, the at least one metallic pad may be exclusively at a lower main surface of the component. In such a scenario, care should be taken that the at least one pad is properly aligned with respect to a metallic connection structure of this pad beneath the component. In yet another embodiment, a component having at least one pad on each of the two opposing main surfaces thereof may be embedded at least partially in the stamped design layer structure so that metallic connection structures for contacting said pads may be formed above and below the component.

As photoresist or NIL resist material, it may be preferred to use a permanent dielectric resist material that remains in the substrate or PCB. However, also temporary resist materials can be used for the manufacturing of fine interconnection copper structures with a line space ratio L/S smaller than 40 µm/40 µm, especially smaller than 20 µm/20 µm. Especially preferred for smaller structures than 20 µm may be a Nanoimprint Lithography process with an UV-curable NIL resist.

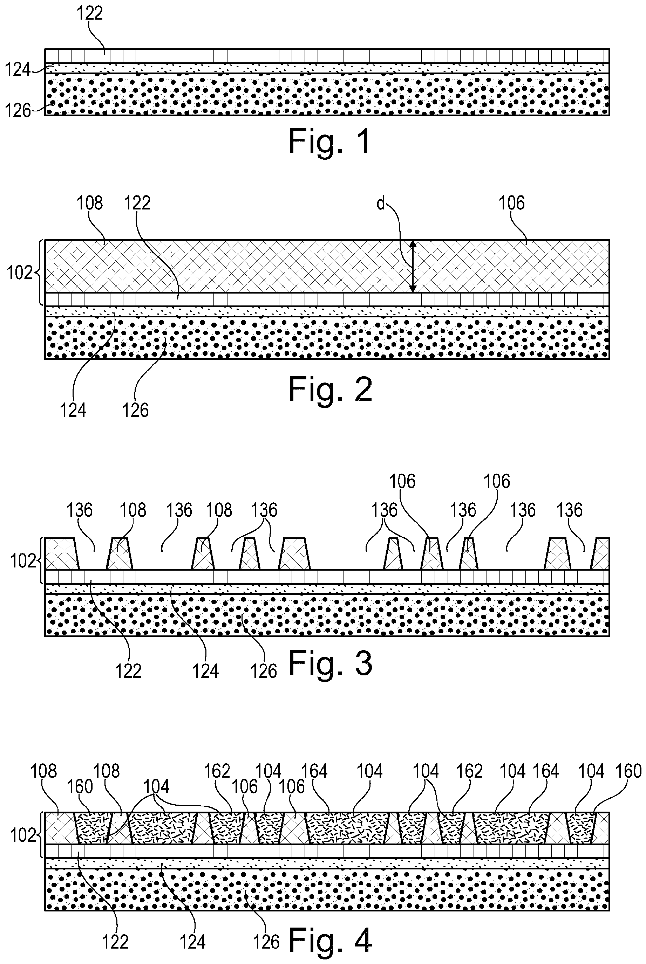

Figure 1 to Figure 8 illustrate cross-sectional views of structures obtained during carrying out a method of manufacturing a component carrier 100 according to an exemplary embodiment of the invention, shown in Figure 8. In Figure 1 to Figure 8, a production route for manufacturing an integrated circuit substrate-type or a printed circuit board-type component carrier 100 is illustrated, which comprises embedding multi-dies and forming fine interconnection structures. Embedded components 112 may be assembled in a chip-first as well as in a chip-last process.

A starting point of the manufacturing method according to Figure 1 to Figure 8 is illustrated in **Figure 1****.** On an optional release layer 124 which is arranged on a carrier 126, a metal base 122 (such as a sputtered metallic seed layer or an attached metal foil, wherein the metal may be copper) may be formed. The release layer 124 may have poorly adhesive properties and may be formed for example of polytetrafluoroethylene. The release layer 124 (which may also be denoted as detach film) may also be a UV-release layer which may be released by ultraviolet radiation. However, the release layer may also be configured to be released by electromagnetic radiation apart from the UV range and/or by the supply of thermal energy. For example, a temporary carrier 126 may be provided as a supporting glass plate or a steel plate which can be removed before completing manufacture of the component carrier 100. In particular in an embodiment in which the carrier 126 remains part of the readily manufactured component carrier 100 (i.e. is not temporary), the release layer 124 may be omitted.

Referring to **Figure 2****,** an electrically insulating layer structure 106 embodied as a design layer structure 108 may be dispensed directly on the metal base 122. Preferably, the design layer structure 108, after dispensing, covers the entire surface of the metal base 122. After dispensing a continuous layer of design layer structure material on the metal base 122, said continuous layer may be structured to obtain the illustrated patterned design layer structure 108. The metal base 122 and the design layer structure 108 may form the basis of a layer stack 102. For example, a thickness d of the design layer structure 108 may be in a range from 0.1 µm to 25 µm. Hence, this may make it possible to create a very thin build-up. Advantageously, the design layer structure 108 may be configured as Nanoimprint Lithography (NIL) layer. In other words, the metal base 122 may be coated with an NIL imprintable resist. After formation on the metal base 122, the design layer structure 108 may still be at least partially uncured, i.e. may be in particular still capable of cross-linking or polymerizing. For instance, the design layer structure 108 may be embodied as a permanent NIL UV (ultraviolet) resist coating. Other kinds of curing (in particular thermal curing and/or curing in another wavelength range) may be possible as well.

In order to obtain the structure shown in **Figure 3****,** the design layer structure 108 may be stamped on the metal base 122 by a profiled working mold (not shown) so that predefined surface portions of the metal base 122 are exposed with respect to the stamped design layer structure 108.

Thus, the illustrated surface profile may be stamped in the design layer structure 108. For this purpose, a working mold (not shown in Figure 3, compare Figure 9) may be pressed into the still deformable design layer structure 108 so that a surface profile of the working mold is transferred into an inverse surface profile imprinted in the design layer structure 108. Descriptively speaking, the created surface profile in the design layer structure 108 corresponds to an electrically conductive pattern to be formed. In the shown embodiment, formation of a surface profile in the design layer structure 108 may create a plurality of indentations 136.

As can be taken from Figure 3 as well, the formed indentations 136 in the design layer structure 108 taper inwardly. All indentations 136 have the same depth (different than in Figure 7, where different indentations depths are formed). This is the result of a corresponding tapering shape of protrusions of the working mold creating the indentations 136 in the design layer structure 108. Forming tapering (rather than vertical) indentations 136 may advantageously suppress issues concerning undesired adhesion between the working mold and the design layer structure 108. With vertically extending sidewalls, a high friction between working mold and design layer structure 108 may occur, which may lead to defects and a low imprinting speed. With tapering sidewalls of the working mold and indentations 136 in the design layer structure 108, a high processing velocity and a low defect rate may be obtained.

Advantageously, the design layer structure 108 may be cured simultaneously during the process of stamping. For this purpose, the working mold (preferably optically transparent, for instance made of glass, transparent, flexible, cross-linked silicone rubbers, and/or a combination of both) may be provided with a curing UV lamp configured for emitting UV radiation. More specifically, said UV lamp may emit UV radiation during imprinting indentations 136 in the design layer structure 108. This accelerates the manufacturing process and makes a subsequent curing procedure dispensable. As an alternative to a UV lamp, also another optical emitter or a heat source may be used for curing. Such an optical emitter or heat source may be integrally formed with the working mold, or may be provided as a separate member. A device for stamping design layer structure 108 using a working mold is illustrated in Figure 9. Simultaneously with the profiling, or subsequently, the design layer structure 108 may be cured by subjecting the deformed design layer structure 108 to heat or appropriate electromagnetic radiation, such as UV radiation.

Under undesired circumstances it may happen that residues of the design layer structure 108 remain, after stamping indentations 136 by the working mold, in the indentations 136 which shall be processed for creating a respective through hole. Since this undesired phenomenon may be critical for a subsequent continuation of the manufacturing process, it may be advantageously possible to remove, preferably by plasma etching, residues of the design layer structure 108 in at least one bottom region of the indentations 136 of the profiled design layer structure 108. Advantageously, stamping the design layer structure 108 on the metal base 122 may expose portions of the metal base 122. This may properly prepare the structure shown in Figure 3 for subsequent electroplating (compare Figure 4).

The formation of the indentations 136 by stamping using a working mold may also ensure that exposed surface portions of the design layer structure 108 delimiting indentations 136 have a very low roughness Ra of preferably less than 50 nm. This makes the manufacture of tiny structures possible and may lead to a component carrier 100 having excellent high-frequency properties.

In particular, a roll-to-plate process may lead to permanent UV-NIL imprinting, so that the obtained surface profile may define subsequently formed vias and chip soldering areas.

Referring to **Figure 4****,** an electrically conductive layer structure 104 is formed in the indentations 136 of the electrically insulating layer structure 106. More specifically, the electrically conductive layer structure 104 is formed in the indentations 136 on the exposed portions of the metal base 122 by plating. In particular, said plating process may comprise an electroless plating stage for lining the indentations 136 with a metallic seed layer. Electroless metal outside of the indentations 136 may be removed, for instance by a lithography and etching process. Advantageously, an electroplating process (for instance galvanic plating) may be executed for filling the indentations 136 with metal, such as copper. The electroplating process can be promoted by the presence of exposed surface portions of the metal base 122 and/or by the (optional) seed layer.

By the described plating process, the indentations 136 may be selectively filled with metal to thereby form vertical through connections 160 (in particular copper vias), component accommodation areas 164 (which may also be denoted as chip areas filling) and alignment marks 162. Thus, copper traces and areas for the subsequent placement of the components 112 as well as alignment marks 162 are plated via a bottom up galvanic copper plating process (more specifically by semi-additive processing, SAP). Hence, besides the fine line structures, alignment marks 162, vias and pad areas for the placement of components 112 face-up on copper are structured as well.

Referring to **Figure 5****,** connection medium 120 is applied to exposed metallic surfaces of the component accommodation areas 164. More specifically, a die attach sinter paste may be applied as connection medium 120 to the component accommodation areas 164, for example by screen printing. More generally, sinter paste may be printed on the copper areas using the alignment marks 162 for instance by dispensing, screen printing or ink jetting. If a component 112 shall be assembled by diffusion soldering, solder (as another example for connection medium 120) can be placed on pads of the component 112 and/or on the component accommodation areas 164. More specifically, Cu, Ag or Sn sinter paste or a mixture thereof may be applied as connection medium 120 by screen printing. It is also possible to carry out galvanic plating of Cu-Sn-Ag sinter paste on the component accommodation areas 164 for thermal bonding of components 112. For example, such a Cu-Sn-Ag sinter paste may be formed by plating different layers of different metals one after the other (i.e. layer by layer) before executing a sinter process to create an alloy. Otherwise, it may also be possible to execute the process layer by layer of each metal (such as Cu/Sn/Cu... Sn), wherein the obtained result can already contain some content of Ag. Instead of dispensing sinter paste, it may also be possible to execute for instance Solid-Liquid Interdiffusion (SLID) bonding via galvanic plating.

Referring to **Figure 6****,** electronic components 112, each having pads 118 arranged face-up, are assembled on the connection medium 120. Since the pads 118 of the components 112 are arranged face-up, they may be used advantageously as alignment marks for subsequent processing. Preferably, the electronic components 112 are semiconductor chips. Such dies with face-up orientation may be connected to the connection medium 120 in particular by thermal sintering with a high accuracy of for example better than 3 µm.

After drying of the connection medium 120 (in particular sinter paste), the electronic components 112 are assembled by a thermal bonding process on their target positions with high alignment accuracy by using the alignment marks 162. Any bonding process and bonding material that form a reliable electric connection between the respective component 112 and the assigned component accommodation area 164 can be used. The thermal bonding process can be also applied as a touch die stage followed by final sintering by curing of the sinter paste in a curing oven by an appropriate curing process. Furthermore, after the bonding process, the component pads 118 shall withstand all subsequent PCB processes (such as filling with NIL resist and pressing at temperatures above 200°C) without delamination of the components 112 from the assigned component accommodation area 164.

Referring to **Figure 7****,** a second design layer structure 110, which can also be embodied as Nanoimprint Lithography (NIL) dielectric, may be applied on top of the assembled electronic components 112 as well as on top of the exposed first design layer structure 108, on top of the assigned component accommodation area 164, and on top of the exposed surfaces of the electrically conductive layer structure 104. Thereby, the electronic components 112 are embedded in the stack 102 so that the electronic components 112 are covered by dielectric material of design layer structure 110. More specifically, the entire dielectric surrounding of the embedded components 112 is formed by the design layer structure 110.

Thereafter, a surface profile of the further design layer structure 110 is stamped for forming tapering indentations 136 in the further design layer structure 110. Said indentations 136 are formed with different depth and different length in the further design layer structure 110, as shown in Figure 7. Thereby, trace-shaped and via-shaped indentations 136 are created in the further design layer structure 110. As described above for design layer structure 108, also further design layer structure 110 may be processed so that stamping and curing occur simultaneously.

Said indentations 136 in the further design layer structure 110 comprise through holes 136' extending through the entire further design layer structure 110 and/or blind holes 136" extending through only part of the further design layer structure 110. Thus, the stamping forms indentations 136 of different depth and/or different length in the further design layer structure 110. More specifically, the through holes 136' have a larger depth and/or a smaller length than the blind holes 136". In the readily manufactured component carrier 100, the through holes 136' may form vertical electrically filled vias, whereas the blind holes 136" may form horizontal electrically conductive traces (which may be denoted as embedded traces). As a result of the stamping, indentations 136 may be obtained which comprise through holes 136' (which may later form metal filled vias) and blind holes 136" (which may later form electrically conductive traces) characterized by different depths and different lengths in the further design layer structure 110. An etching (preferably plasma etching) process may be carried out optionally to ensure that no residues of the further design layer structure 110 remain at the bottoms of the through holes 136'.

Still referring to Figure 7, the NIL resist may coat and fill areas on and above the electronic components 112 with permanent dielectric. For this purpose, NIL imprinting with high accuracy (in particular with an accuracy of better than 3 µm concerning vias and traces) may be repeated once or several times. Thus, after thermal bonding of the components 112, the spaces between the components 112 can be filled with an appropriate resin. Any process for filling up the spaces in between the components 112 can be used, for instance a printing process.

In particular, plasma etching of residues of the further design layer structure 110 (embodied as NIL resist) on bottom of the indentations 136 may be carried out for exposing copper. Thereafter, seed layer deposition followed by copper plating may be executed for filling up the via- and trace-type indentations 136. This may be followed, in turn, by etching of the seed layer to separate copper traces.

Thus, permanent NIL resist may be dispensed for overmolding components 112 and for filling of spaces in between the components 112 with NIL resist. Structuring of the NIL resist for formation of vias may be accomplished to contact the pads 118 of the components 112 and as the basis for the formation of fine lines and interconnection structures.

To put it shortly, a highly advantageous feature of the processing according to Figure 7 is to form the basis for electric contacts of the component pads 118 using NIL technology.

**Figure 8** illustrates a component carrier 100 obtained by the described manufacturing process. The illustrated component carrier 100 may be embodied as printed circuit board or integrated circuit substrate.

In order to obtain component carrier 100 according to Figure 8 based on the structure shown in Figure 7, an additional electrically conductive layer structure 104 may be formed in the indentations 136 of the further design layer structure 110 by plating. In particular, said plating process may comprise an electroless plating stage for lining the indentations 136 with a metallic seed layer. Electroless metal outside of the indentations 136 may be removed, for instance by a lithography and etching process. Furthermore, an electroplating process (for instance galvanic plating) may be executed for filling the indentations 136 of the further design layer structure 110 with metal, such as copper. The electroplating process can be promoted by the presence of exposed surface portions of the electrically conductive layer structure 104 of design layer structure 108 and by the (optional) seed layer.

As a basis for the formation of the additional electrically conductive layer structure 104 in the further design layer structure 110, a copper seed layer may be deposited (for instance by copper sputtering or electroless deposition of copper). Optionally, an adhesion promoter may be deposited prior to seed layer deposition for improving adhesion. Additionally or alternatively, surface activation may be executed before seed layer deposition. Further optionally, a working mold for stamping the further design layer structure 110 may be provided with a locally higher roughness in corresponding specific areas in order to ease subsequent seed layer formation with proper adhesion to the NIL resist surface. It is also possible to form a selective protective layer for selective inking of highest areas of the pattern. Furthermore, a selective galvanic copper plating process may be carried out. Plasma etching of the temporary protective layer may be executed as well. Furthermore, etching of the copper seed layer may be executed for formation of a desired pattern.

The component carrier 100 according to Figure 8 comprises stack 102 having electrically conductive layer structures 104 (which may be formed by plated copper) and electrically insulating layer structures 106 (which may be formed by NIL dielectric). The electrically insulating layer structures 106 are composed of design layer structures 108, 110 each having a stamped surface profile. A plurality of chip-type components 112 are embedded in the stack 102 and are covered by portions of the design layer structure 110, by portions of the electrically conductive layer structures 104 and by connection medium 120.

The electrically conductive layer structures 104 comprise electrically conductive traces 114 and are delimited by the further design layer structure 110. Consequently, said electrically conductive traces 114 have an advantageously low roughness Ra of for example less than 50 nm. This is a result of the formation of the electrically conductive traces 114 in a stamped surface profile of the further design layer structure 110. Moreover, the electrically conductive layer structures 104 comprise vertical through connections 116 which are delimited by the design layer structures 108, 110. Advantageously, the vertical through connections 116 may have a high depth-to-diameter ratio of larger than 1. This may ensure a low-ohmic electric connection in vertical direction which can be manufactured with reasonable effort.

Since the components 112 have their pads 118 being oriented face-up, the pads 118 may not only contribute to an electric connection of the components 112 but may also function as alignment marks during the manufacturing process.

The four vertical sidewalls of the cuboid embedded components 112 are completely covered by dielectric material of the design layer structure 110. The upper horizontal sidewall of each embedded component 112 is partially covered by dielectric material of the further design layer structure 110 and is partially covered by metallic material of an electrically conductive layer structure 104. The lower horizontal sidewall of each embedded component 112 is in contact with an assigned connection medium 120.

Although not shown in Figure 8, it may be possible to remove the carrier 126 at the release layer 124 prior to completing manufacture of the component carrier 100. In such a scenario, the carrier 126 is a temporary carrier. Alternatively, it may be possible that the carrier 126 is a permanent carrier which remains part of the readily manufactured component carrier 100. The metal base 122 may remain part of the readily manufactured component carrier 100, or may be removed as well.

Although not shown, after the stack up of the component carrier 100 according to Figure 8 is completed and several components 112 have been embedded in several layers of stack 102, the carrier 126 may be removed, for example by detaching the release layer 124. For example, said detaching process may be triggered by electromagnetic radiation (such as UV radiation) and/or thermal energy. After etching the base metal 122 (which may be a copper metal layer), the alignment marks 162 can be used from the other side to place and solder one or more further electronic components 112 on the outer side. Such a chip last approach may be accomplished with an alignment accuracy below 10 µm, preferably below 5 µm. After placement of such at least one further surface mounted component 112 on top of the component carrier 100, underfilling and/or overmolding of the one or more surface mounted components 112 may be done. The complete stack up of component carrier 100 may then be soldered on a mounting base, such as a mother board or other kind of printed circuit board (PCB).

As an alternative to the embodiment shown in Figure 1 to Figure 8, it is also possible that not the entire dielectric surrounding of the embedded components 112, but only part thereof, is constituted by NIL material. Alternatively, it is for instance also possible to form a bottom portion of a dielectric surrounding of the embedded component(s) 112 by a non-stampable dielectric (for instance FR4) and to form a top portion of the dielectric surrounding by one or more design layer structures 108, 110. Further alternatively, it is for instance also possible to form a top portion of a dielectric surrounding of the embedded component(s) 112 by a non-stampable dielectric (for instance FR4) and to form a bottom portion of the dielectric surrounding by one or more design layer structures 108, 110. This may allow in particular to form a dielectric surrounding by NIL material with its excellent properties in terms of fine lining only where needed, whereas the rest of the dielectric surrounding may be formed with very low effort by standard PCB dielectric (such as prepreg or FR4).

**Figure 9** shows a device 150 for stamping a surface profile in a design layer 108, 110 using a working mold 172 according to an exemplary embodiment.

As shown, a planar uncured design layer structure 108, 110 may be formed on a carrier 126 which may be transported along a support 168. Material of the design layer structure 108, 110 may be applied to the carrier 126 from a reservoir 170. The working mold 172 may have a designable and preferably tapering surface profile 174 and may stamp an inverse and preferably tapering surface profile 176 in the design layer structure 108, 110. For this purpose, the working mold 172 may for example rotate using rotating wheels (not shown) to thereby produce a continuous sheet with a stamped profiled design layer structure 108, 110. By a light source 180 (such as a UV lamp), the design layer structure 108, 110 may be cured during stamping.

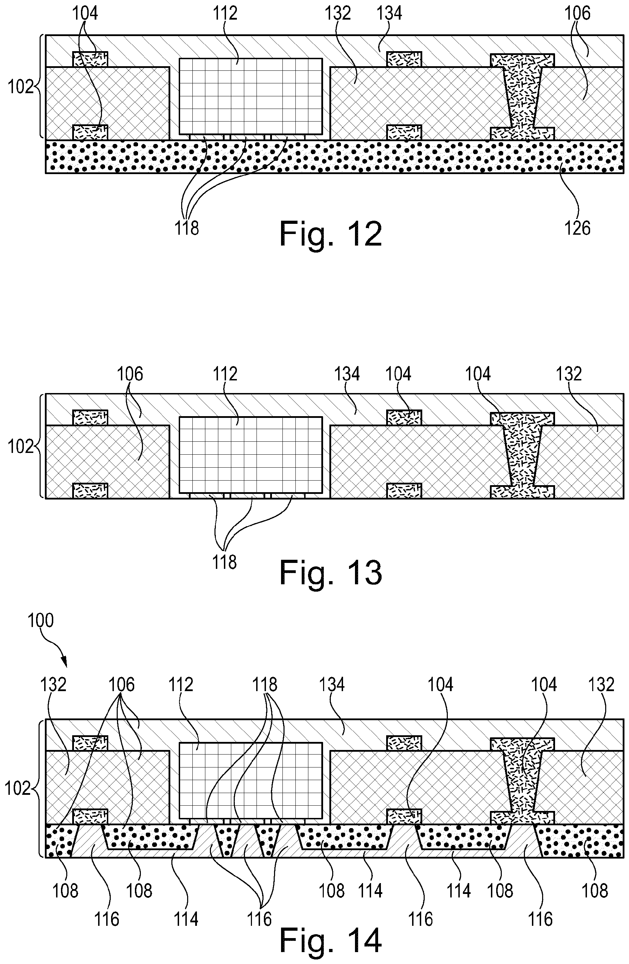

Figure 10 to Figure 14 illustrate cross-sectional views of structures obtained during carrying out a method of manufacturing a component carrier 100 according to an exemplary embodiment of the invention, shown in Figure 14.

Referring to **Figure 10****,** a core 132 with a through hole 130 is provided as part of a stack 102. For instance, the core 132 may be a plate of fully cured resin, for instance epoxy resin, comprising reinforcing particles such as glass fibers. As shown, a patterned metal layer is provided at a lower main surface of the core 132. A further patterned metal layer is formed at an upper main surface of the core 132. Both patterned metal layers may be structured copper foils and may form electrically conductive layer structures 104 on and/or in the core-type electrically insulating layer structure 106. The patterned metal layers may be interconnected by a further electrically conductive layer structure 104 extending vertically through core 132. A bottom of the through hole 130 is closed by attaching a temporary carrier 126 to a bottom of the core 132. An electronic component 112, such as a semiconductor chip, is mounted in the through hole 130 on the temporary carrier 126. Pads 118 of the electronic component 112 are oriented face-down.

Referring to **Figure 11****,** a sheet-type dielectric 134 may be provided for subsequent attachment to a top side of the core 132 and of the component 112. For example, the dielectric 134 is a pure resin layer, which may be free of glass fibers and free of filler particles. This may ensure proper flowability characteristics during subsequent lamination. In another embodiment, the sheet-type dielectric 134 may be embodied as a further stampable design layer structure, in particular NIL resist. Such a further stampable design layer structure may be structured.

Referring to **Figure 12****,** the dielectric 134 is attached to the top side of the core 132 and of the component 112 by lamination, i.e. the application of heat and/or pressure. Hence, the core 132, the component 112, and the dielectric 134 may be connected or fixed with each other by lamination. Consequently, the component 112 is partially surrounded by the dielectric 134.

Referring to **Figure 13****,** the temporary carrier 126 may be subsequently removed.

Referring to **Figure 14****,** a design layer structure 108 may be applied to a bottom side of the structure shown in Figure 13, i.e. may be applied to the core 132, to the component 112 (including part of its pads 118) and to part of the dielectric 134 which has filled gaps between component 112 and core 132 during lamination.

Thereafter, a surface profile may be stamped in the bottom surface of the design layer structure 108, for instance using a work mold as the one shown in Figure 9. As a result of said stamping process, the pads 118 of the component 112 may be selectively exposed beyond the design layer structure 108. Furthermore, the stamping process may be adjusted so that also the electrically conductive layer structures 104 on the bottom side of the core 132 are exposed.

Thereafter, a further electrically conductive layer structure 104 may be formed by plating in indentations of the stamped design layer structure 108 for contacting the exposed pads 118 and the exposed electrically conductive last structure 104 on the bottom side of the core 132. This may involve the formation of one or more electrically conductive traces 114 and/or one or more vertical through connections 116. As a result, component 112 is properly embedded in stack 102 and is electrically connected within the component carrier 100. Furthermore, the dielectric surrounding of component 112 is partially provided by dielectric 134 and partially by the design layer structure 108.

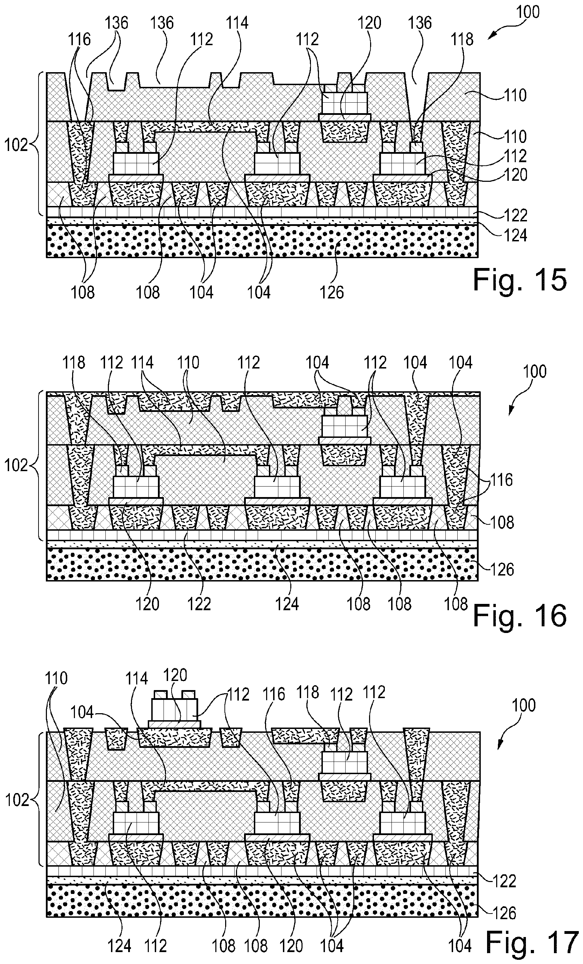

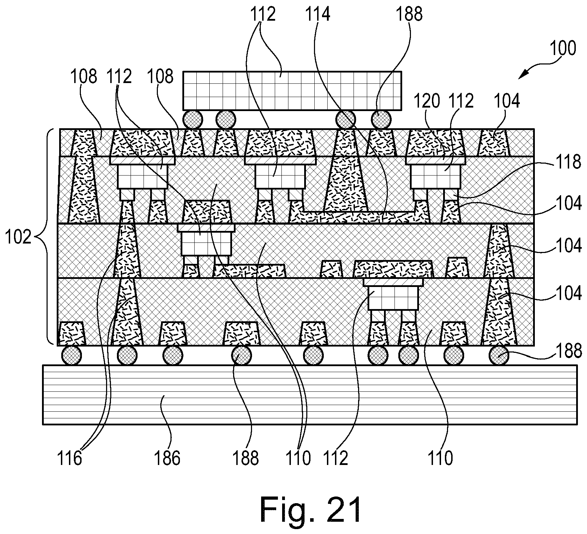

Figure 15 to Figure 21 illustrate cross-sectional views of structures obtained during carrying out a method of manufacturing a component carrier 100 according to an exemplary embodiment of the invention, shown in Figure 21.

Starting point for the manufacturing process of **Figure 15** is a component carrier 100 shown in Figure 8. On this basis, connection medium 120 (such as a solder or sinter paste) may be applied on an exposed electrically conductive layer structure 104 on the top side of the component carrier 100 shown in Figure 8. Thereafter, a further component 112 may be assembled on said connection medium 120. After that, a further (i.e. a third) design layer structure 110 is applied and stamped on top of said further component 112 and the top of the component carrier 100 shown in Figure 8. Thereby, further indentations 136 are formed in the top main surface of the structure shown in Figure 15. This process corresponds to the process described above referring to Figure 7.

Referring to **Figure 16****,** the indentations 136 formed according to Figure 15 can be filled by metallic material for forming a further electrically conductive layer structure 104. This process corresponds to the process described above referring to Figure 8. Said metallic material may be, for example, plated metal, sinter paste and/or magnetic paste.

Referring to **Figure 17****,** further connection medium 120 (such as a solder or sinter paste) may be applied on an exposed electrically conductive layer structure 104 on the top side of the structure shown in Figure 16. Thereafter, yet another component 112 may be assembled on said further connection medium 120.

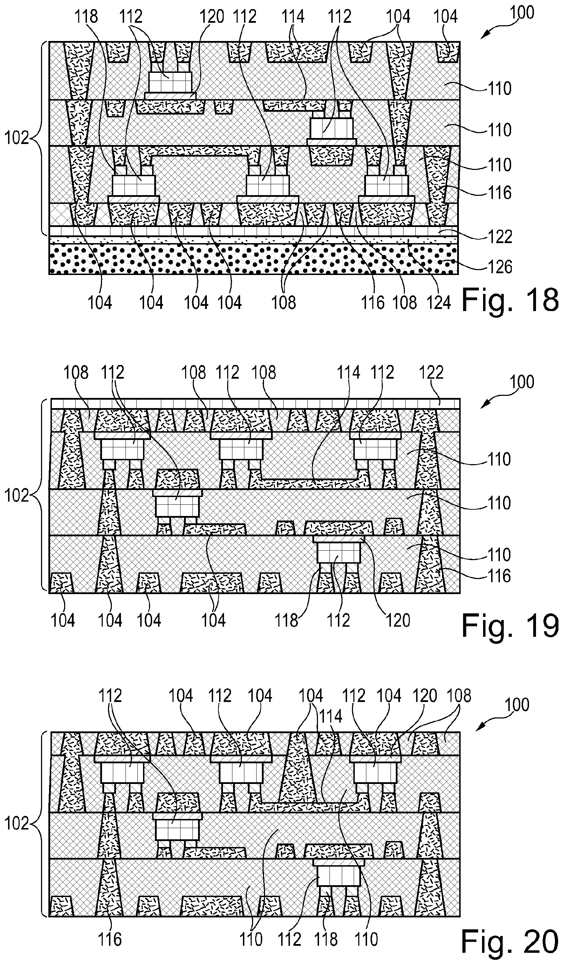

Referring to **Figure 18****,** yet another (i.e. a fourth) design layer structure 110 is applied and stamped on top of said other component 112 and the top of the third design layer structure 110. Obtained indentations can then be filled by further metallic material for forming yet another electrically conductive layer structure 104.

Referring to **Figure 19****,** the temporary carrier 126 may be removed at release layer 124, and the obtained structure may be turned upside down. Thus, a rotation of the panel may be carried out, and the (for example glass) carrier 126 may be detached.

**Figure 20** shows the structure according to Figure 19 after removal of metal base 122. By etching of the copper layer which may form metal base 122 (and optionally a plasma back etching of the uppermost NIL resist) finest structures on the outer layer may be formed. A flat surface of outer layers may be obtained due to the flatness of the carrier 126.

Referring to **Figure 21****,** the component carrier 100 according to Figure 20 may be mounted on a mounting base 186, such as a motherboard or a printed circuit board. On top of the component carrier 100, a further component 112 may be assembled by surface mounting. Connection structures 188, such as solder balls, may be used for connecting said surface mounted component 112 with component carrier 100 and/or for connecting the mounting base 186 with the component carrier 100.

Although not shown, an underfill may be inserted between component carrier 100 and surface mounted component 112. It is also possible that surface mounted component 112 on component carrier 100 is overmolded (not shown). Also not shown is that a surface finish may be applied on the outer main surface(s) (for example gold on metal structures and/or solder resist on dielectric structures).

A chip last placement of one or more surface mounted components 112 may be accomplished with connection structures 188, such as tin solder balls or any sinter paste. In particular, it may be possible to solder a substrate-type component carrier 100 with embedded components 112 as well as with one or more chip last components 112 on top on the mother board or other kind of mounting base 186.

It should be noted that the term "comprising" does not exclude other elements or steps and the "a" or "an" does not exclude a plurality. Also elements described in association with different embodiments may be combined.

It should also be noted that reference signs in the claims shall not be construed as limiting the scope of the claims.

Implementation of the invention is not limited to the preferred embodiments shown in the figures and described above. Instead, a multiplicity of variants are possible which use the solutions shown and the principle according to the invention even in the case of fundamentally different embodiments.

## Claims

1. A component carrier (100) which comprises:
a stack (102) comprising at least one electrically conductive layer structure (104) and at least one electrically insulating layer structure (106), wherein the at least one electrically insulating layer structure (106) comprises at least one design layer structure (108, 110) having a stamped surface profile; and
a component (112) being embedded in the stack (102) and being at least partially covered by the at least one design layer structure (108, 110).

2. The component carrier (100) according to claim 1, wherein electrically conductive traces (114) of the at least one electrically conductive layer structure (104) delimited by the at least one design layer structure (108, 110) have a roughness Ra of less than 100 nm, in particular less than 50 nm.

3. The component carrier (100) according to claim 1 or 2, wherein vertical through connections (116) of the at least one electrically conductive layer structure (104) delimited by the at least one design layer structure (108, 110) have a depth-to-diameter ratio of larger than 1, in particular of larger than 1.5.

4. The component carrier (100) according to any of claims 1 to 3, comprising at least one of the following features:
wherein the component (112) comprises at least one pad (118) being oriented face-up and/or face-down;
wherein a connection area of the embedded component (112) is exclusively in contact with the at least one design layer structure (108, 110);
wherein at least a part of one vertical sidewall of the embedded component (112) is covered by the at least one design layer structure (108, 110), in particular at least five sidewalls of the embedded component (112) are at least partially covered by the at least one design layer structure (108, 110);
wherein a first portion, in particular a bottom portion, of a dielectric surrounding of the embedded component (112) is formed by a non-stampable dielectric, in particular comprising a resin, and a second portion, in particular a top portion, of the dielectric surrounding is formed by the at least one design layer structure (108, 110);
wherein the embedded component (112) is mounted on at least one of the at least one electrically conductive layer structure (104) by a connection medium (120), in particular sinter material, solder, or glue;
wherein the at least one design layer structure (108, 110) has at least one indentation (136) positioned lateral to the embedded component (112);
wherein the at least one design layer structure (108, 110) having the stamped surface profile comprises a Nanoimprint Lithography dielectric.

5. A method of manufacturing a component carrier (100), wherein the method comprises:
forming a stack (102) comprising at least one electrically conductive layer structure (104) and at least one electrically insulating layer structure (106) ;
stamping a surface profile in at least one design layer structure (108, 110) of the at least one electrically insulating layer structure (106); and
embedding a component (112) in the stack (102) so that the component (112) is at least partially covered by the at least one design layer structure (108, 110).

6. The method according to claim 5, wherein the method comprises forming an entire dielectric surrounding of the embedded component (112) by the at least one design layer structure (108, 110).

7. The method according to claim 6, wherein forming the entire dielectric surrounding of the embedded component (112) by the at least one design layer structure (108, 110) is carried out by:
forming and stamping a first design layer structure (108) at least partially below the component (112); and
forming and stamping a second design layer structure (110) at least partially above the component (112).

8. The method according to claim 5, wherein the method comprises:
forming a first portion, in particular a bottom portion, of a dielectric surrounding of the embedded component (112) by a non-stampable dielectric, in particular a resin with reinforcing particles or a resin without reinforcing particles; and
forming a second portion, in particular a top portion, of the dielectric surrounding by the at least one design layer structure (108, 110).

9. The method according to any of claims 5 to 8, wherein the method comprises:
forming at least one of the at least one design layer structure (108, 110) on a metal base (122);
stamping the at least one of the at least one design layer structure (108, 110) on the metal base (122) to thereby expose portions of the metal base (122); and
plating at least part of the at least one electrically conductive layer structure (104) on or above the exposed portions of the metal base (122).

10. The method according to claim 9, wherein the plating comprises electroplating.

11. The method according to any of claims 5 to 10, wherein the method comprises arranging the component (112) with at least one pad (118) arranged face-up.

12. The method according to claim 11, wherein the method comprises using the at least one pad (118) arranged face-up as alignment mark for subsequent processing.

13. The method according to any of claims 5 to 12, wherein the method comprises:
forming a metal base (122) on a release layer (124) on a temporary carrier (126);
forming at least one of the at least one design layer structure (108, 110) on the metal base (122); and
removing the temporary carrier (126) at the release layer (124) prior to completing manufacture of the component carrier (100).

14. The method according to claim 5, wherein the method comprises:
providing a core (132) of the stack (102) with a through hole (130);
closing the through hole (130) by attaching a temporary carrier (126) to a bottom of the core (132);
mounting the component (112) in the through hole (130) on the temporary carrier (126);
subsequently partially surrounding the component (112) by a dielectric (134) of the at least one electrically insulating layer structure (106);
subsequently removing the temporary carrier (126);
forming the at least one design layer structure (108, 110) at the core (132) and at the component (112);
stamping the surface profile in the at least one design layer structure (108, 110) for exposing at least one pad (118) of the component (112); and
forming at least one of the at least one electrically conductive layer structure (104) in the stamped at least one design layer structure (108, 110) for contacting the exposed at least one pad (118).

15. The method according to any of claims 5 to 14, comprising at least one of the following features:
wherein stamping the surface profile in the at least one design layer structure (108, 110) comprises forming tapering indentations (136) in the at least one design layer structure (108, 110);
wherein stamping the surface profile in the at least one design layer structure (108, 110) comprises forming indentations (136) of different depth and/or different length in the at least one design layer structure (108, 110);
wherein stamping the surface profile in the at least one design layer structure (108, 110) comprises forming trace-shaped and/or via-shaped and/or combined trace-and-via-shaped indentations (136) in the at least one design layer structure (108, 110);
wherein the method comprises configuring the at least one design layer structure (108, 110) as Nanoimprint Lithography dielectric;
wherein the method comprises curing the at least one design layer structure (108, 110), in particular simultaneously stamping and curing the at least one design layer structure (108, 110).
